(19) **Europäisches Patentamt**

**European Patent Office**

**Office européen des brevets**

(11) **EP 0 990 164 B1**

(12) **EUROPÄISCHE PATENTSCHRIFT**

(45) Veröffentlichungstag und Bekanntmachung des Hinweises auf die Patenterteilung:
**06.03.2002 Patentblatt 2002/10**

(21) Anmeldenummer: **98936096.1**

(22) Anmeldetag: **04.06.1998**

(51) Int Cl.$^7$: **G01R 31/02**

(86) Internationale Anmeldenummer:
**PCT/DE98/01518**

(87) Internationale Veröffentlichungsnummer:
**WO 98/58269 (23.12.1998 Gazette 1998/51)**

(54) **ÜBERWACHUNGSVERFAHREN UND ÜBERWACHUNGSGERÄT FÜR EIN KABEL**

METHOD AND DEVICE FOR MONITORING A CABLE

PROCEDE ET APPAREIL DE SURVEILLANCE D'UN CABLE

(84) Benannte Vertragsstaaten:
**AT BE CH DE FR IT LI**

(30) Priorität: **17.06.1997 DE 19725611**

(43) Veröffentlichungstag der Anmeldung:
**05.04.2000 Patentblatt 2000/14**

(73) Patentinhaber: **SIEMENS AKTIENGESELLSCHAFT**
**80333 München (DE)**

(72) Erfinder:
• **KARL, Harald**
  **D-91058 Erlangen (DE)**
• **LINDNER, Friedrich**
  **D-96138 Burgebrach (DE)**
• **LINK, Dietmar**
  **D-91325 Adelsdorf (DE)**

(56) Entgegenhaltungen:
WO-A-90/11532        WO-A-90/11533
DE-A- 3 513 846      FR-A- 2 264 288

• **PATENT ABSTRACTS OF JAPAN vol. 7, no. 184 (P-216), 13. August 1983 & JP 58 085176 A (NIPPON DENSHIN DENWA KOSHA), 21. Mai 1983**
• **PATENT ABSTRACTS OF JAPAN vol. 8, no. 254 (P-315), 21. November 1984 & JP 59 125075 A (NAKAYAMA TADAHARU)**

EP 0 990 164 B1

**Beschreibung**

Die vorliegende Erfindung betrifft ein Überwachungsverfahren für ein Kabel mit einem Kabelanfang und einem Kabelende, wobei das Kabel einen eine Betriebsspannung führenden elektrischen Leiter, eine den Leiter umgebende innere Isolationsschicht mit einem Innenwiderstand, eine die innere Isolationsschicht umgebende Schirmung sowie eine die Schirmung umgebende äußere Isolationsschicht mit einem Außenwiderstand aufweist, sowie das hiermit korrespondierende Überwachungsgerät.

Aus der WO 90/11 532 ist ein Kabel mit einem Kabelanfang und einem Kabelende bekannt, wobei das Kabel einen eine Betriebsspannung führenden elektrischen Leiter, eine den Leiter umgebende innere Isolationsschicht mit einem Innenwiderstand, eine die innere Isolationsschicht umgebende Schirmung sowie eine die Schirmung umgebende äußere Isolationsschicht mit einem Außenwiderstand aufweist.

Die eingangs erwähnten Überwachungsverfahren und Überwachungsgeräte werden unter anderem zur Überprüfung von Kabeln eingesetzt, mittels derer die Einspeisung von Strom zwischen Unterwerk und Streckeneinspeisung bei U- und S-Bahnen mit Gleichstrombetrieb erfolgt.

Um die Betriebssicherheit des Kabels zu gewährleisten und das Kabel bei Alterung rechtzeitig ersetzen zu können, müssen sowohl die innere als auch die äußere Isolationsschicht kontinuierlich auf ihren Zustand überprüft werden. Ferner sollte ein Kurzschluß zwischen Leiter und Schirmung, wie er beispielsweise bei einer Beschädigung durch einen Bagger auftritt, getrennt und schnell erfaßt werden können, um das Kabel in diesem Fall spannungsfrei zu schalten. Ferner darf aus Gründen des Berührschutzes die Spannung zwischen Schirmung und Erdpotential 60 V nicht überschreiten. Darüber hinaus wird oft auch die Überwachung der Unversehrtheit der Schirmung gefordert, da eine Beschädigung der Schirmung zur Folge hätte, daß die Widerstände der Isolationsschichten nicht mehr gemessen werden könnten.

Beim Stand der Technik wird die Schirmung über einen Spannungsteiler zwischen Leiter und Erdpotential auf eine feste Spannung geklemmt. Durch Messung der Spannung zwischen Schirmung und Erdpotential und dem Vergleichen mit einer erwarteten Spannung kann das Verhältnis zwischen Außenwiderstand und Innenwiderstand ermittelt werden. Weicht die gemessene Spannung um mehr als eine Toleranzschwelle von der erwarteten Spannung ab, so ist - je nach Abweichungsrichtung - das Verhältnis von Innenwiderstand zu Außenwiderstand entweder zu groß oder zu klein. Die Überwachung der Schirmung wird dadurch erreicht, daß die Schirmung am Kabelende über einen Widerstand entweder mit dem Leiter oder mit dem Erdpotential verbunden wird. Bei einer Unterbrechung der Schirmung ändert sich dann das Schirmungspotential am Überwachungsgerät. Je nach Art der Beschaltung wird die Schirmungsunterbrechung dann entweder als Schluß zwischen Leiter und Schirmung oder als Schluß zwischen Schirmung und Erde angezeigt.

Der Stand der Technik ist insofern nachteilig, als nicht die Absolutwerte der Widerstände gemessen werden, sondern nur ihr Verhältnis zueinander. Gleichmäßige Änderungen beider Widerstände bleiben daher unerkannt, solange das Verhältnis der Widerstände innerhalb der Toleranzgrenze bleibt.

Die Aufgabe der vorliegenden Erfindung besteht darin, ein Überwachungsverfahren und das hiermit korrespondierende Überwachungsgerät zu schaffen, bei dem der Innen- und der Außenwiderstand absolut meßbar sind.

Die Aufgabe wird für das Überwachungsverfahren mit folgenden Schritten gelöst:

-    die Schirmung wird über einen Vorwiderstand mit dem Leiter und über eine veränderliche Spannungsquelle mit einem Erdpotential verbunden;
-    die veränderliche Spannungsquelle gibt nacheinander mindestens eine obere und eine untere Spannung ab, so daß in der Schirmung bei Abgabe der unteren Spannung ein unterer Strom und bei Abgabe der oberen Spannung ein oberer Strom fließt;
-    der untere Strom und der obere Strom werden gemessen und
-    aus der Betriebsspannung, der unteren Spannung, der oberen Spannung, dem unteren Strom und dem oberen Strom werden der Innenwiderstand und der Außenwiderstand ermittelt.

Das Überwachungsgerät hat folgende Merkmale:

-    Es weist einen Leiteranschluß für den Leiter, einen Schirmanschluß für die Schirmung und einen Erdanschluß für ein Erdpotential auf;
-    zwischen dem Leiteranschluß und dem Schirmanschluß ist ein Vorwiderstand angeordnet;
-    zwischen dem Schirmanschluß und dem Erdanschluß ist eine Spannungsquelle angeordnet, durch die mindestens eine obere und eine untere Spannung abgebbar ist;
-    zwischen dem Schirmanschluß und der Spannungsquelle ist ein Strommesser angeordnet, durch den ein in der Schirmung fließender Schirmstrom meßbar ist;
-    die Spannungsquelle und der Strommesser sind mit einer Kontrollschaltung verbunden, durch die aus der Betriebsspannung, der unteren Spannung, der oberen Spannung, einem bei Abgabe der unteren Spannung fließenden unteren Schirmstrom und einem bei Abgabe der oberen Spannung fließenden oberen Schirmstrom der Innenwiderstand und der Außenwiderstand ermittelbar sind.

Vorteilhafterweise sollte auch eine Unterbrechung der Schirmung als solche detektierbar sein. Dies wird für das Überwachungsverfahren dadurch erreicht,

- daß der untere Strom und der obere Strom am Kabelanfang gemessen werden,
- daß am Kabelende ein Teststrom in die Schirmung eingespeist wird,
- daß ein in der Schirmung bei Einspeisung des Teststromes fließender Schirmstrom gemessen wird und
- daß aus der Stärke der Schirmstromänderung abgeleitet wird, ob die Schirmung zwischen Kabelanfang und Kabelende unterbrochen ist oder nicht.

Dementsprechend ist das Überwachungsgerät vorteilhaft derart ausgebildet,

- daß es einen Zusatzanschluß für eine Zusatzader aufweist;
- daß es eine Stromquelle aufweist, die zwischen dem Schirmanschluß und dem Zusatzanschluß angeordnet ist;
- daß die Stromquelle von der Kontrollschaltung ansteuerbar ist und
- daß durch die Kontrollschaltung eine durch das Ansteuern der Stromquelle verursachte Schirmstromänderung auf Schirmunterbrechung zwischen Kabelanfang und Kabelende auswertbar ist.

Weitere Vorteile und Einzelheiten ergeben sich aus der nachfolgenden Beschreibung eines Ausführungsbeispiels. Dabei zeigen

Fig. 1 den Aufbau eines zu überwachenden Kabels,
Fig. 2 eine Prinzipschaltung zur Überwachung des Kabels und
Fig. 3 ein Blockschaltbild eines Überwachungsgeräts.

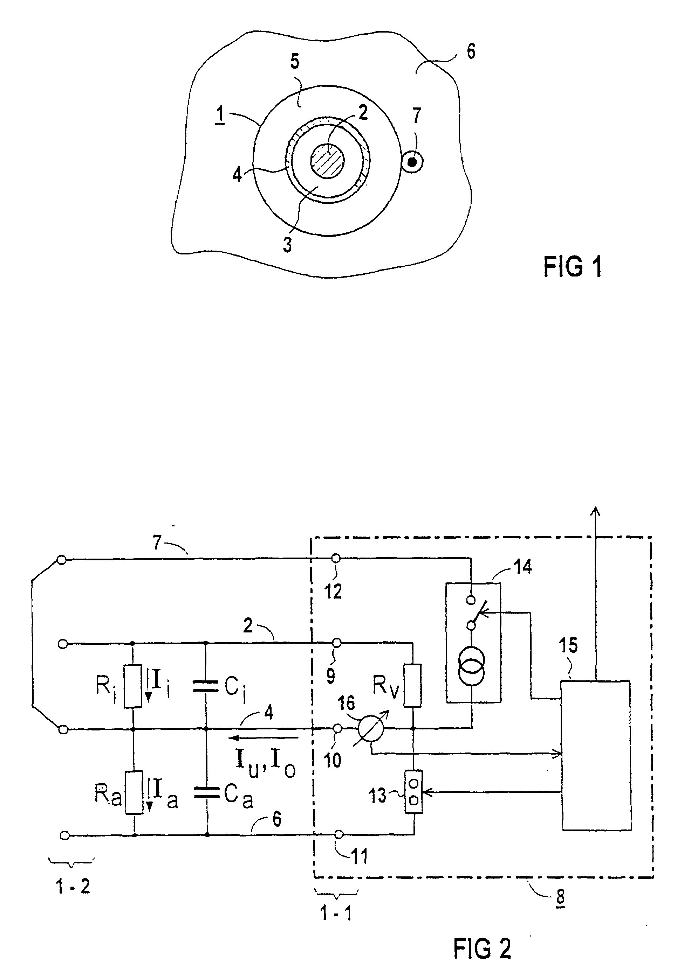

Gemäß Fig. 1 besteht ein zu überwachendes Kabel 1 aus einem Mittelleiter 2, der von einer inneren Isolationsschicht 3 umgeben ist. Die innere Isolationsschicht 3 ist von einer Schirmung 4 umgeben. Die Schirmung 4 ist von einer äußeren Isolationsschicht 5 umgeben, welche den Schirm 4 gegenüber dem das Kabel 1 umgebenden Erdreich 6 isoliert. Das Kabel 1 hat selbstverständlich eine bestimmte Länge, z. B. 500 m, und folglich auch einen Kabelanfang 1-1 und ein Kabelende 1-2 (s. Fig. 2). Im Betrieb führt der Leiter 2 eine Betriebs-Gleichspannung Ub von z. B. 750 V. Im vorliegenden Fall ist dem Kabel 1 ferner zusätzlich noch eine Zusatzader 7 beigefügt, welche gegenüber dem Erdreich 6 und dem Kabel 1 isoliert ist.

Wie allgemein bekannt ist, ist der Widerstand der Isolationsschichten 3, 5 zwar sehr hoch (im Bereich von etlichen Megaohm), aber nicht unendlich. Die Widerstände der Isolationsschichten 3, 5 sind ferner von verschiedenen Randbedingungen abhängig, beispielsweise sind sie altersabhängig. Ferner kann das Kabel auch beschädigt werden, z. B. durch einen Bagger.

Zur Messung des Außenwiderstandes Ra der äußeren Isolationsschicht 5 und des Innenwiderstandes Ri der inneren Isolationsschicht 3 geschieht mittels der in Fig. 2 dargestellten Prinzipschaltung. Das Kabel 5 ist dabei in Fig. 2 in seinem Ersatzschaltbild dargestellt. Dementsprechend sind der Leiter 2 und die Schirmung 4 über den Innenwiderstand Ri sowie eine Innen-Kabelkapazität Ci verbunden, die Schirmung 4 und das Erdpotential 6 über den Außenwiderstand Ra und eine AußenKabelkapazität Ca. Gemäß Fig. 2 ist das Kabel 1 an seinem Kabelanfang 1-1 mit einem Überwachungsgerät 8 verbunden. Dabei ist der Leiter 2 mit einem Leiteranschluß 9, die Schirmung mit einem Schirmanschluß 10, das Erdpotential 6 mit einem Erdanschluß 11 und die Zusatzader 7 mit einem Zusatzanschluß 12 verbunden. Innerhalb des Überwachungsgeräts 8 sind der Leiteranschluß 9 und der Schirmanschluß 10 über einen Vorwiderstand Rv miteinander verbunden, der Schirmanschluß 10 und der Erdanschluß 11 über eine Spannungsquelle 13. Schließlich weist das Überwachungsgerät 8 noch eine Stromquelle 14 auf, die zwischen dem Schirmanschluß 10 und dem Zusatzanschluß 12 angeordnet ist.

Das Überwachungsgerät 8 wird von einer Kontrollschaltung 15 gesteuert und arbeitet wie folgt:

Zunächst steuert die Kontrollschaltung 15 die Spannungsquelle 13 derart an, daß diese eine untere Spannung Uu von z. B. 20 V abgibt. Ein dann in der Schirmung 4 fließender unterer Strom Iu wird mittels eines Strommessers 16 gemessen und an die Kontrollschaltung 15 gemeldet. Sodann steuert die Kontrollschaltung 15 die Spannungsquelle 13 derart an, daß diese eine obere Spannung Uo von z. B. 60 V abgibt. Auch ein hiermit korrespondierender oberer Strom Io wird gemessen und an die Kontrollschaltung 15 gemeldet. Schließlich wird - wahlweise bei der unteren Spannung Uu oder der oberen Spannung Uo die Stromquelle 14 von der Kontrollschaltung 15 derart angesteuert, daß diese einen Teststrom It über die Zusatzader 7 am Kabelende 1-2 in die Schirmung 4 einspeist. Auch ein sich nun ergebender Schirmstrom I wird vom Strommesser 16 erfaßt und an die Kontrollschaltung 15 gemeldet. Danach beginnt - entweder unmittelbar folgend oder nach einer gewissen Pause - ein neuer Meßzyklus.

Aus dem - entweder gemessenen oder der Kontrollschaltung 15 bekannten - Wert der Betriebsspannung Ub, der unteren Spannung Uu, dem hiermit korrespondierenden unteren Strom Iu, der oberen Spannung Uo und dem hiermit korrespondierenden oberen Strom Io kann die Kontrollschaltung 15 nun die Absolutwerte für den Innenwiderstand Ri und den Außenwiderstand Ra berechnen. Die untere Spannung Uu und die obere Spannung Uo können beliebig sein, solange die Differenz zwischen ihnen groß genug ist. Insbesondere kann die Gesamtschaltung bei einer der Spannungen Uu, Uo abgeglichen sein, so daß bei dieser Spannung kein Schirmstrom Iu bzw. Io fließt. Dies ist aber nicht zwingend erforderlich.

Die Berechnung erfolgt nach folgendem Prinzip:

Wenn am Leiter 2 die Betriebsspannung Ub anliegt und die variable Spannungsquelle 13 die untere Spannung Uu abgibt, so daß in der Schirmung 4 der untere Strom Iu fließt, so ergeben sich die Ausgangsgleichungen

$$Ra \cdot Ia + Ri \cdot Ii = Ub \tag{1}$$

$$Iu + Ii = Ia \tag{2}$$

und

$$Ri \cdot Ii = Ub - Uu \tag{3}$$

wobei Ii und Ia die durch den Innenwiderstand Ri bzw. den Außenwiderstand Ra fließenden Ströme sind. Durch Einsetzen von Gleichung (2) in Gleichung (1) erhält man die Gleichung

$$Ra \cdot Iu + Ra \cdot Ii + Ri \cdot Ii = Ub \tag{4}$$

Durch Auflösen von Gleichung (3) nach Ii und Einsetzen in die Gleichung (4) erhält man nach einfachem Umformen die Gleichung

$$Ra \cdot (Iu + (Ub-Uu)/Ri) = Uu \tag{5}$$

In analoger Weise erhält man die Gleichung

$$Ra \cdot (Io + (Ub-Uo)/Ri) = Uo \tag{6}$$

In den - linear unabhängigen - Gleichungen (5) und (6) sind lediglich die Werte für den Innenwiderstand Ri und den Außenwiderstand Ra unbekannt. Diese sind somit aus den Gleichungen (5) und (6) analytisch bestimmbar. Der Innenwiderstand Ri und der Außenwiderstand Ra ergeben sich zu

$$Ri = Ub \cdot (Uo-Uu)/(Uu \cdot Io - Uo \cdot Iu) \tag{7}$$

und

$$Ra = Ub \cdot (Uo-Uu)/[Ub \cdot (Io-Iu) + (Uo \cdot Iu-Uu \cdot Io)] \tag{8}$$

Die Gleichungen (7) und (8) werden besonders einfach, wenn die untere Spannung Uu 0 Volt beträgt und die Schaltung bei der oberen Spannung Uo abgeglichen ist, Io also 0 Ampere beträgt. Denn dann vereinfachen sich die Gleichungen (7) und (8) zu

$$Ri = Ub/Iu \qquad (9)$$

und

$$Ra = Ub\cdot Uo/[(Ub-Uo)\cdot Iu] \qquad (10)$$

Die Detektion, ob die Schirmung 4 zwischen Kabelanfang 1-1 und Kabelende 1-2 unterbrochen ist, beruht darauf, daß sich der gemessene Schirmstrom I bei Einspeisung des Teststroms It ändern muß. Ändert sich der Schirmstrom I nicht bzw. nur innerhalb einer Toleranzgrenze, so muß der Schirm 4 zwischen Kabelanfang 1-1 und Kabelende 1-2 unterbrochen sein.

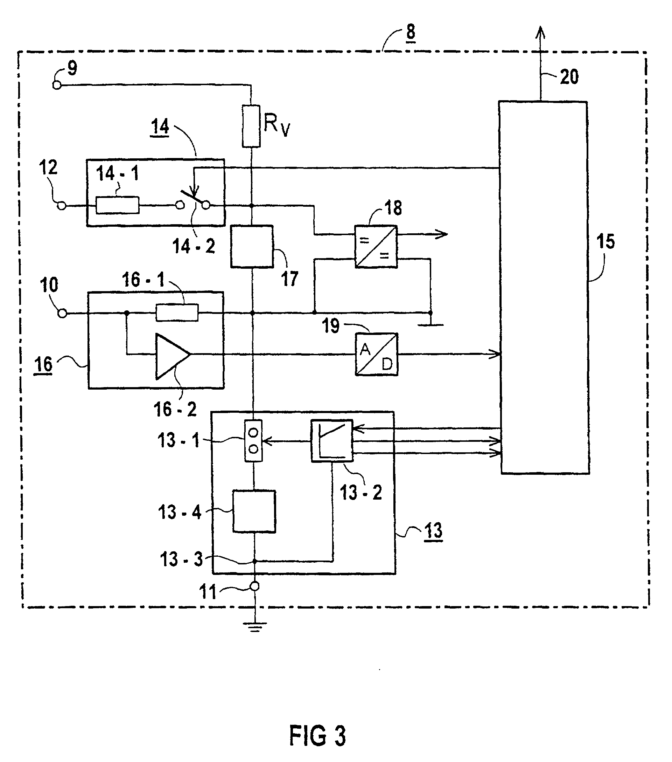

Fig. 3 zeigt nun ein detaillierteres Blockschaltbild des Überwachungsgeräts 8. Die gleichen Elemente wie in Fig. 2 sind dabei mit den gleichen Bezugszeichen versehen. Wie aus Fig. 3 ersichtlich ist, ist die Spannungsquelle 13 eine geregelte Spannungsquelle, weist also außer dem eigentlichen Spannungserzeuger 13-1 noch eine Spannungsregelung 13-2 auf. Diese Spannungsregelung 13-2 erhält von der Kontrollschaltung15 eine Sollspannung vorgegeben, also eine der Spannungen Uu und Uo. Sie regelt dann den Spannungserzeuger 13-1 derart, daß die am Knotenpunkt 13-3 anliegende Istspannung sich dieser Sollspannung angleicht. Das Erreichen der Sollspannung wird an die Kontrollschaltung 15 zurückgemeldet. Ferner wird auch überwacht, ob die erreichte Spannung eine Grenzspannung überschreitet. Auch dies wird an die Kontrollschaltung 15 gemeldet. Bei Überschreiten der Grenzspannung spricht darüber hinaus eine Überspannungsschutzschaltung 13-4 an, welche dazu dient, Beschädigungen des Überwachungsgeräts 8 zu verhindern.

Ferner ist ersichtlich, daß zwischen dem Vorwiderstand Rv und dem Schirmanschluß 10 eine Spannungsbegrenzungsschaltung 17 angeordnet ist. Diese begrenzt die zwischen dem Vorwiderstand Rv und der Spannungsquelle 13 liegende Spannung auf z. B. 30 V. Der Spannungsbegrenzungsschaltung 17 ist ein Spannungsumsetzer 18 parallelgeschaltet, über den die Kontrollschaltung 15 und der später noch zu erläuternde Analog/Digital-Wandler 19 mit Energie versorgt werden. Die Spannungsbegrenzungsschaltung 17 ist im einfachsten Fall als Zenerdiode ausgebildet. Ihr kann gegebenenfalls noch ein Kondensator parallelgeschaltet sein. Der Spannungsumsetzer 18 ist üblicherweise als Schaltnetzteil ausgebildet.

Wie ferner ersichtlich ist, besteht der Strommesser 16 aus einem Meßwiderstand 16-1, dem ein Verstärker 16-2 zugeordnet ist. Dessen analoges Ausgangssignal wird dann dem Analog/Digital-Wandler 19 zugeführt, der dieses Analogsignal in ein Digitalsignal umwandelt und der digital arbeitenden Kontrollschaltung 15 zuführt.

Die Stromquelle 14 wiederum besteht aus einem Strombegrenzungswiderstand 14-1 und einem Schalter 14-2. Sie ist schirmanschlußseitig über die Spannungsbegrenzungsschaltung 17 mit dem Schirmanschluß 10 verbunden.

Die Kontrollschaltung 15 kann wahlweise die gemessenen Spannungs- Uu, Uo und Stromwerte Iu, Io selbst auswerten und über einen Ausgabekanal 20 direkt Stellsignale ausgeben, welche z. B. das Kabel 1 spannungsfrei schalten, wenn die Schirmung 4 unterbrochen wird. Ebenso ist es aber auch möglich, daß die Kontrollschaltung 15 lediglich die Spannungs- Uu, Uo und Stromwerte Iu, Io mißt und die gemessenen Werte Uu, Uo, Iu, Io an eine übergeordnete Steuerung übermittelt, welche dann die Auswertung der Meßwerte Uu, Uo, Iu, Io übernimmt.

Im geschilderten Ausführungsbeispiel war dem Kabel 1 eine eigene Zusatzader 7 zugeordnet, um am Kabelende 1-2 einen Teststrom in die Schirmung 4 einspeisen zu können. In der Praxis werden üblicherweise zwei Kabel 1 ohne Zusatzadern 7 parallel zueinander verlegt. Die Leiter 2 der Kabel 1 sind in diesem Fall elektrisch parallelgeschaltet, führen also beide die Betriebsspannung Ub. Die Schirmungen 4 der Kabel 1 hingegen werden an ihren Kabelenden 1-2 miteinander verbunden, also elektrisch in Serie geschaltet. Die Schirmung 4 des einen Kabels 1 wird dann am Kabelanfang 1-1 dieses Kabels 1 mit dem Schirmanschluß 10, die Schirmung 4 des anderen Kabels 1 am Kabelanfang 1-1 des anderen Kabels 1 mit dem Zusatzanschluß 12 verbunden.

**Patentansprüche**

**1.** Überwachungsverfahren für ein Kabel (1) mit einem Kabelanfang (1-1) und einem Kabelende (1-2), wobei das Kabel (1) einen eine Betriebsspannung (Ub) führenden elektrischen Leiter (2), eine den Leiter (2) umgebende innere Isolationsschicht (3) mit einem Innenwiderstand (Ri), eine die innere Isolationsschicht (3) umgebende Schirmung (4) sowie eine die Schirmung (4) umgebende äußere Isolationsschicht (5) mit einem Außenwiderstand (Ra) aufweist, mit folgenden Verfahrensschritten:

- die Schirmung (4) wird über einen Vorwiderstand (Rv) mit dem Leiter (2) und über eine veränderliche Spannungsquelle (13) mit einem Erdpotential (6) verbunden;
- die veränderliche Spannungsquelle (13) gibt nacheinander mindestens eine obere (Uo) und eine untere Spannung (Uu) ab, so daß in der Schirmung (4) bei Abgabe der unteren Spannung (Uu) ein unterer Strom (Iu) und bei Abgabe der oberen Spannung (Uo) ein oberer Strom (Io) fließt;
- der untere Strom (Iu) und der obere Strom (Io) werden gemessen und
- aus der Betriebsspannung (Ub), der unteren Spannung (Uu), der oberen Spannung (Uo), dem unteren Strom (Iu) und dem oberen Strom (Io) werden der Innenwiderstand (Ri) und der Außenwiderstand (Ra) ermittelt.

2. Überwachungsverfahren nach Anspruch 1, **dadurch gekennzeichnet,**

- **daß** der untere Strom (Iu) und der obere Strom (Io) am Kabelanfang (1-1) gemessen werden,
- **daß** am Kabelende (1-2) ein Teststrom (It) in die Schirmung (4) eingespeist wird,
- **daß** ein in der Schirmung (4) bei Einspeisung des Teststromes (It) fließender Schirmstrom (I) gemessen wird und
- **daß** aus der Stärke der Schirmstromänderung abgeleitet wird, ob die Schirmung (4) zwischen Kabelanfang (1-1) und Kabelende (1-2) unterbrochen ist oder nicht.

3. Überwachungsgerät für ein Kabel (1) mit einem Kabelanfang (1-1) und einem Kabelende (1-2), wobei das Kabel (1) einen eine Betriebsspannung (Ub) führenden elektrischen Leiter (2), eine den Leiter (2) umgebende innere Isolationsschicht (3) mit einem Innenwiderstand (Ri), eine die innere Isolationsschicht (3) umgebende Schirmung (4) sowie eine die Schirmung (4) umgebende äußere Isolationsschicht (5) mit einem Außenwiderstand (Ra) aufweist, mit folgenden Merkmalen:

- es weist einen Leiteranschluß (9) für den Leiter (2), einen Schirmanschluß (10) für die Schirmung (4) und einen Erdanschluß (11) für ein Erdpotential (6) auf;
- zwischen dem Leiteranschluß (9) und dem Schirmanschluß (10) ist ein Vorwiderstand (Rv) angeordnet;
- zwischen dem Schirmanschluß (10) und dem Erdanschluß (11) ist eine Spannungsquelle (13) angeordnet, durch die mindestens eine obere (Uo) und eine untere Spannung (Uu) abgebbar sind;
- zwischen dem Schirmanschluß (10) und der Spannungsquelle (13) ist ein Strommesser (16) angeordnet, durch den ein in der Schirmung (4) fließender Schirmstrom (I) meßbar ist;
- die Spannungsquelle (13) und der Strommesser (16) sind mit einer Kontrollschaltung (15) verbunden, durch die aus der Betriebsspannung (Ub), der unteren Spannung (Uu), der oberen Spannung (Uo), einem bei Abgabe der unteren Spannung (Uu) fließenden unteren Schirmstrom (Iu) und einem bei Abgabe der oberen Spannung (Uo) fließenden oberen Schirmstrom (Io) der Innenwiderstand (Ri) und der Außenwiderstand (Ra) ermittelbar sind.

4. Überwachungsgerät nach Anspruch 3, **dadurch gekennzeichnet, daß** die Kontrollschaltung (15) eine digital arbeitende Kontrollschaltung (15) ist und daß zwischen dem Strommesser (16) und der Kontrollschaltung (15) ein Analog/ Digital-Wandler (19) angeordnet ist.

5. Überwachungsgerät nach Anspruch 3 oder 4, **dadurch gekennzeichnet,**

- **daß** zwischen dem Vorwiderstand (Rv) und dem Schirmanschluß (10) eine Spannungsbegrenzungsschaltung (17) angeordnet ist,
- **daß** der Spannungsbegrenzungsschaltung (17) ein Spannungsumsetzer (18) parallelgeschaltet ist und
- **daß** die Kontrollschaltung (15), ggf. auch der Analog/Digital-Wandler (19), von dem Spannungsumsetzer (18) mit Energie versorgt wird bzw. werden.

6. Überwachungsgerät nach Anspruch 3, 4 oder 5, **dadurch gekennzeichnet,**

- **daß** die Spannungsquelle (13) eine Spannungsregelung (13-2) aufweist und
- **daß** die Spannungsregelung (13-2) sowohl ein Erreichen einer von der Kontrollschaltung (15) vorgegebenen Sollspannung als auch ein Überschreiten einer Grenzspannung an die Kontrollschaltung (15) meldet.

7. Überwachungsgerät nach einem der Ansprüche 3 bis 6, **dadurch gekennzeichnet, daß** zwischen der Spannungsquelle (13) und dem Erdanschluß (11) eine Überspannungsschutzschaltung (13-4) angeordnet ist.

8. Überwachungsgerät nach einem der Ansprüche 3 bis 7, **dadurch gekennzeichnet,**

- **daß** es einen Zusatzanschluß (12) für eine Zusatzader (7) aufweist;
- **daß** es eine Stromquelle (14) aufweist, die zwischen dem Schirmanschluß (10) und dem Zusatzanschluß (12) angeordnet ist;
- **daß** die Stromquelle (14) von der Kontrollschaltung (15) ansteuerbar ist und
- **daß** durch die Kontrollschaltung (15) eine durch das Ansteuern der Stromquelle (14) verursachte Schirmstromänderung auf Schirmunterbrechung zwischen Kabelanfang (1-1) und Kabelende (1-2) auswertbar ist.

9. Überwachungsgerät nach Anspruch 5 und 8, **dadurch gekennzeichnet,**

- **daß** die Stromquelle (14) aus einem Schalter (14-2) mit einem Strombegrenzungswiderstand (14-1) besteht und
- **daß** die Stromquelle (14) schirmanschlußseitig über die Spannungsbegrenzungsschaltung (17) mit dem Schirmanschluß (10) verbunden ist.

**Claims**

1. Method for monitoring a cable (1) having a cable beginning (1-1) and a cable end (1-2), with the cable (1) having an electrical conductor (2) which conducts an operating voltage (Ub), an inner insulating layer (3) surrounding the conductor (2) and having an internal resistance (Ri), a shield (4) surrounding the inner insulating layer (3), and also an outer insulating layer (5) surrounding the shield (4) and having an external resistance (Ra), having the following method steps:

- the shield (4) is connected to the conductor (2) by way of a series resistor (Rv) and to an earth potential (6) by way of a variable voltage source (13);
- the variable voltage source (13) successively emits at least one upper voltage (Uo) and one lower voltage (Uu) so that when the lower voltage (Uu) is emitted a lower current (Iu) flows in the shield (4) and when the upper voltage (Uo) is emitted an upper current (Io) flows in the shield (4) ;
- the lower current (Iu) and the upper current (Io) are measured; and
- the internal resistance (Ri) and the external resistance (Ra) are determined from the operating voltage (Ub), the lower voltage (Uu), the upper voltage (Uo), the lower current (Iu) and the upper current (Io).

2. Monitoring method according to claim 1, **characterized**

- **in that** the lower current (Iu) and the upper current (Io) are measured at the cable beginning (1-1),
- **in that** a test current (It) is fed into the shield (4) at the cable end (1-2),
- **in that** a shield current (I) that flows in the shield (4) when the test current (It) is fed in is measured, and
- **in that** from the size of the change in the shield current it is deduced whether the shield (4) is interrupted or not between the cable beginning (1-1) and the cable end (1-2).

3. Device for monitoring a cable (1) having a cable beginning (1-1) and a cable end (1-2), with the cable (1) having an electrical conductor (2) which conducts an operating voltage (Ub), an inner insulating layer (3) surrounding the conductor (2) and having an internal resistance (Ri), a shield (4) surrounding the inner insulating layer (3), and also an outer insulating layer (5) surrounding the shield (4) and having an external resistance (Ra), having the following features:

- it has a conductor terminal (9) for the conductor (2), a shield terminal (10) for the shield (4) and an earth terminal (11) for an earth potential (6);
- a series resistor (Rv) is arranged between the conductor terminal (9) and the shield terminal (10) ;
- arranged between the shield terminal (10) and the earth terminal (11) there is a voltage source (13) by means of which at least one upper voltage (Uo) and one lower voltage (Uu) can be emitted;
- arranged between the shield terminal (10) and the voltage source (13) there is a current meter (16) by means of which a shield current (I) that flows in the shield (4) can be measured;
- the voltage source (13) and the current meter (16) are connected to a control circuit arrangement (15) by means of which the internal resistance (Ri) and the external resistance (Ra) can be determined from the operating voltage (Ub), the lower voltage (Uu), the upper voltage (Uo), a lower shield current (Iu) that flows when the lower voltage (Uu) is emitted, and an upper shield current (Io) that flows when the upper voltage (Uo) is emitted.

4.  Monitoring device according to claim 3, **characterized in that** the control circuit arrangement (15) is a digitally operating control circuit arrangement (15), and **in that** an analog/digital converter (19) is arranged between the current meter (16) and the control circuit arrangement (15).

5.  Monitoring device according to claim 3 or 4, **characterized**

    -   **in that** a voltage-limiting circuit arrangement (17) is arranged between the series resistor (Rv) and the shield terminal (10),
    -   **in that** a voltage converter (18) is connected in parallel with the voltage-limiting circuit arrangement (17), and
    -   **in that** the control circuit arrangement (15), and if applicable also the analog/digital converter (19), is or are supplied with energy by the voltage converter (18).

6.  Monitoring device according to claim 3, 4 or 5, **characterized**

    -   **in that** the voltage source (13) has a voltage control (13-2), and
    -   **in that** the voltage control (13-2) signals to the control circuit arrangement (15) not only when a nominal voltage preset by the control circuit arrangement (15) is reached, but also when a voltage limit is exceeded.

7.  Monitoring device according to one of claims 3 to 6, **characterized in that** an overvoltage-protection circuit arrangement (13-4) is arranged between the voltage source (13) and the earth terminal (11).

8.  Monitoring device according to one of claims 3 to 7, **characterized**

    -   **in that** it has an additional terminal (12) for an additional core (7);
    -   **in that** it has a current source (14) which is arranged between the shield terminal (10) and the additional terminal (12);
    -   **in that** the current source (14) can be activated by the control circuit arrangement (15), and
    -   **in that** a change in the shield current caused by the activation of the current source (14) can be evaluated by the control circuit arrangement (15) to determine whether there is an interruption in the shield between the cable beginning (1-1) and the cable end (1-2).

9.  Monitoring device according to claim 5 and 8, **characterized**

    -   **in that** the current source (14) consists of a switch (14-2) with a current-limiting resistor (14-1), and
    -   **in that** the current source (14) on the shield terminal side is connected to the shield terminal (10) by way of the voltage-limiting circuit arrangement (17).

**Revendications**

1.  Procédé de contrôle d'un câble (1) ayant un début de câble (1-1) et une fin de câble (1-2), le câble (1) comportant un conducteur électrique (2) conduisant une tension de fonctionnement (Ub), une couche isolante interne (3) entourant le conducteur (2) et ayant une résistance interne (Ri), un blindage (4) entourant la couche isolante interne (3), ainsi qu'une couche isolante externe (5) entourant le blindage (4) et ayant une résistance externe (Ra), avec les étapes de procédé suivantes :

    -   on relie le blindage (4) au conducteur (2) par l'intermédiaire d'une résistance série (Rv) et à un potentiel terrestre (6) par l'intermédiaire d'une source de tension variable (13) ;
    -   la source de tension variable (13) délivre successivement au moins une tension supérieure (Uo) et une tension inférieure (Uu) de telle sorte qu'il passe dans le blindage (4) un courant inférieur (Iu) lors de la délivrance de la tension inférieure (Uu) et un courant supérieur (Io) lors de la délivrance de la tension supérieure (Uo) ;
    -   on mesure le courant inférieur (Iu) et le courant supérieur (Io) ; et
    -   à partir de la tension de fonctionnement (Ub), de la tension inférieure (Uu), de la tension supérieure (Uo), du courant inférieur (Iu) et du courant supérieur (Io), on détermine la résistance interne (Ri) et la résistance externe (Ra).

**2.** Procédé de contrôle selon la revendication 1, **caractérisé par le fait que**

- on mesure le courant inférieur (Iu) et le courant supérieur (Io) au début du câble (1-1) ;
- on introduit à la fin de câble (1-2) un courant de test (It) dans le blindage (4) ;
- on mesure un courant de blindage (I) passant dans le blindage (4) lors de l'introduction du courant de test (It) ; et
- on détermine à partir de l'intensité de la variation de courant de blindage si le blindage (4) est coupé ou non entre le début de câble (1-1) et la fin de câble (1-2).

**3.** Appareil de contrôle d'un câble (1) ayant un début de câble (1-1) et une fin de câble (1-2) , le câble (1) comportant un conducteur électrique (2) conduisant une tension de fonctionnement (Ub), une couche isolante interne (3) entourant le conducteur (2) et ayant une résistance interne (Ri), un blindage (4) entourant la couche isolante interne (3) ainsi qu'une couche isolante externe (5) entourant le blindage (4) et ayant une résistance externe (Ra), avec les caractéristiques suivantes :

- il comporte une borne de conducteur (9) pour le conducteur (2), une borne de blindage (10) pour le blindage (4) et une borne de terre (11) pour le potentiel terrestre (6) ;
- une résistance série (Rv) est montée entre la borne de conducteur (9) et la borne de blindage (10) ;
- une source de tension (13) pouvant délivrer au moins une tension supérieure (Uo) et une tension inférieure (Uu) est montée entre la borne de blindage (10) et la borne de terre (11) ;
- un dispositif de mesure de courant (16) pouvant mesurer un courant de blindage (I) passant dans le blindage (4) est monté entre la borne de blindage (10) et la source de tension (13) ;
- la source de tension (13) et le dispositif de mesure de courant (16) sont reliés à un circuit de contrôle (15) qui peut déterminer la résistance interne (Ri) et la résistance externe (Ra) à partir de la tension de fonctionnement (Ub), de la tension inférieure (Uu), de la tension supérieure (Uo), d'un courant de blindage inférieur (Iu) passant lors de la délivrance de la tension inférieure (Uu) et d'un courant de blindage supérieur (Io) passant lors de la délivrance de la tension supérieure (Uo).

**4.** Appareil de contrôle selon la revendication 3, **caractérisé par le fait que** le circuit de contrôle (15) est un circuit de contrôle (15) travaillant de façon numérique et qu'un convertisseur analogique-numérique (19) est monté entre le dispositif de mesure de courant (16) et le circuit de contrôle (15).

**5.** Appareil de contrôle selon la revendication 3 ou 4, **caractérisé par le fait que**

- un circuit de limitation de tension (17) est monté entre la résistance série (Rv) et la borne de blindage (10) ;
- un convertisseur de tension (18) est branché en parallèle avec le circuit de limitation de tension (17) ; et
- le circuit de contrôle (15) et le cas échéant aussi le convertisseur analogique-numérique (19) sont alimentés en énergie par le convertisseur de tension (18).

**6.** Appareil de contrôle selon la revendication 3, 4 ou 5, **caractérisé par le fait que**

- la source de tension (13) comporte un régulateur de tension (13-2) ; et
- le régulateur de tension (13-2) signale au circuit de contrôle (15) aussi bien l'obtention d'une tension de consigne prescrite par le circuit de contrôle (15) qu'un dépassement d'une tension limite.

**7.** Appareil de contrôle selon l'une des revendications 3 à 6, **caractérisé par le fait qu'**un circuit de protection contre des surtensions (13-4) est monté entre la source de tension (13) et la borne de terre (11).

**8.** Appareil de contrôle selon l'une des revendications 3 à 7, **caractérisé par le fait que**

- il comporte une borne supplémentaire (12) pour un fil supplémentaire (7) ;
- il comporte une source de courant (14) qui est montée entre la borne de blindage (10) et la borne supplémentaire (12) ;
- la source de courant (14) peut être commandée par le circuit de contrôle (15) ; et
- le circuit de contrôle (15) peut évaluer une variation de courant de blindage due à la commande de la source de courant (14) et servant à détecter une coupure entre le début de câble (1-1) et la fin de câble (1-2).

**9.** Appareil de contrôle selon les revendications 5 et 8, **caractérisé par le fait que**

- la source de courant (14) est constituée d'un interrupteur (14-2) avec une résistance de limitation de courant (14-1) ; et
- du côté de la borne de blindage, la source de courant (14) est reliée à ladite borne de blindage (10) par l'intermédiaire du circuit de limitation de courant (17).

FIG 1

FIG 2

FIG 3